Europäisches Patentamt

European Patent Office

Office européen des brevets

(19)

(11) **EP 0 548 542 B1**

(12) **EUROPEAN PATENT SPECIFICATION**

(45) Date of publication and mention
of the grant of the patent:
**23.07.1997   Bulletin 1997/30**

(51) Int Cl.6: **H03B 19/14**, H03G 3/30

(21) Application number: **92119734.9**

(22) Date of filing: **19.11.1992**

(54) **Radiofrequency frequency multiplier comprising an automatic level control cicuit**

Radiofrequenzvervielfachen mit selbsttätiger Pegelsteuerungsschaltung

Multiplicateur de fréquence radio comportant un circuit de commande automatique de niveau

(84) Designated Contracting States:
**DE ES FR GB GR IT SE**

(30) Priority: **27.11.1991   IT   MI913168**

(43) Date of publication of application:
**30.06.1993   Bulletin 1993/26**

(73) Proprietor: **Italtel s.p.a.**
**20149 Milano (IT)**

(72) Inventors:
• **Piloni, Marco**
  **I-20090 Vimodrone MI (IT)**
• **Brambilla, Massimo**
  **I-20050 Ronco Briantino (MI) (IT)**

(56) References cited:
EP-A- 0 241 742          DE-A- 2 155 982
US-A- 3 156 834          US-A- 3 808 539
US-A- 4 398 153

## Description

The present invention lies in the field of the art which concerns the generation of sinusoidal signals with sample frequency and more specifically a radiofrequency frequency multiplier comprising an automatic level control circuit.

It is known that in various applications of the electronic art there arises the problem of having sinusoidal reference signals having an appropriately preset frequency.

For example, in receiving and transmitting equipment it is essential to have a local oscillator signal to actuate the necessary and known frequency conversions.

In radionavigation there is a network of radiobeacons for supervision of the routes travelled by ships and aircraft. Each radiobeacon transmits continuously a very powerful sinusoidal radiofrequency signal of its own.

The cited examples concern, for the sake of brevity, only two of the many possible uses of radiofrequency reference signals.

It is often advantageous to generate said reference signals by using very low-frequency oscillators because this is easier to implement. It is then sufficient to multiply the oscillator signal frequency by the necessary integer number.

Frequency multiplication is known to be carried out by causing the submultiple frequency signal to transit through a device which distorts the input signal and generates the harmonics of a higher order. The multiple frequency signal is obtained by filtering the distorted signal by means of a band-pass filter with narrow band tuned to the corresponding harmonic at the desired frequency.

In the majority of technical applications it is required that the reference signal obtained by frequency multiplication have a constant power level. But in practice there may occur cases in which the oscillator signal level displays ample fluctuations and in this case, if appropriate measures are not taken, even the signal obtained by multiplication is affected by said fluctuations. This eventuality occurs mainly when the oscillator is not placed in the same apparatus including the multiplier, for example when the oscillator signal reaches the multiplier over a coaxial cable.

To remedy the above shortcoming the known reference-signal generators which perform the frequency multiplication also include either a feedback or non-feedback control circuit which regulates the output power level of the signal generated.

In a first known reference-signal generator including a non-feedback control circuit, the latter is an amplitude compressor device placed at the frequency multiplier output.

Said generator, while being easy to make, displays several shortcomings. A first shortcoming is that it excessively limits the dynamics of the oscillator signal power levels. A second shortcoming is that the amplitude compression device introduces an excessive contribution of harmonics of an undesired order. Lastly, stabilization of the power level is poor.

A second known reference-signal generator including a feedback control circuit is disclosed in the document US-A-3808539. In the citation the reference-signal generator is a frequency multiplier belonging to a battery operated radio transmitter. The frequency multiplier includes three capacitively coupled NPN transistors, of which: a first one (Q1) belongs to a preamplifier stage, a second one (Q2) accomplishes the frequency multiplication, and the third one is a RF power amplifier; between the second and the third transistor is placed a band-pass filter for the selection of the RF desired harmonic. A local oscillator (not shown in the Figures) generates the RF sinusoidal input signal to the preamplifier (Q1). The control circuit provides a power detector feedback resistor in the emitter-collettor path of the third transistor to develop a direct current feedback voltage for the emitter-collettor path of the first transistor. This feedback voltage biases the first transistor so that as the battery voltage (and hence RF output power) decreases, the gain of the preamplifier stage is increased to maintain the RF output power of the selected harmonic nearly constant. In addition to the regulation of above, the feedback control circuit is able to stabilize the output power also in consequence of the oscillator signal level fluctuations. In this case the preamplifier stage acts as an oscillator signal variable attenuator, or more in general, as an oscillator signal level regulator.

The principal shortcoming of this second reference-signal generator is that its implementation is very costly, especially when the signal to be frequency-multiplied is in the microwave range. Indeed, in this case it is necessary to provide both the feedback element (power detector) and the oscillator signal level regulator (variable attenuator) in accordance with microwave technology. It is also necessary to insert a coupler between the frequency multiplier output and the feedback element.

Accordingly the purpose of the present invention is to overcome the above shortcomings and indicate a radiofrequency sinusoidal signal generator consisting of a frequency multiplier controlling automatically the power level of the harmonic generated.

To achieve said purpose, the scope of the present invention is a radiofrequency frequency multiplier comprising a transistor which amplifies and distorts an oscillator signal, a band-pass filter placed at the output of the transistor tuned to the desired harmonic at the output, and a control circuit stabilizing the power of said harmonic by automatically varying the polarization voltage of the transistor with variation of the oscillator signal power level, as better described in claim 1.

The main novelty of the frequency multiplier which is the subject of the present invention, in comparison with the known art, is that it includes a control circuit which supplies the transistor while polarizing it. Said circuit can also be seen as an ideal generator of a voltage made variable in accordance with an appropriate regulation function depending on the type of transistor used, the order of the harmonic selected at the output and the power level it is intended to stabilize.

Said control circuit operates under quasi-direct current conditions regardless of the frequency of the signal whose power is controlled. Consequently the radiofrequency frequency multiplier in accordance with the present invention is economical and easy to implement whatever be the frequency of the signal generated. In particular, it is particularly advantageous when the oscillator signal has a frequency in the microwave range.

Another advantage is the fact that the power of the harmonic signal generated is stabilized without introducing limitations in the oscillator signal power level dynamics.

Additional purposes and advantages of the present invention will be made clear by the detailed description given below of an example of embodiment thereof, and the annexed drawings given merely by way of nonlimiting example wherein:-

FIG. 1 shows a partially-block circuit diagram of the radiofrequency frequency multiplier in accordance with the present invention.

FIGS. 2, 3, 4 and 5 show diagrams of some electrical characteristics illustrating the opertation of the radiofrequency frequency multiplier of FIG. 1, and

FIG. 6 shows the detailed circuit diagram of a control block belonging to the frequency multiplier of FIG. 1.

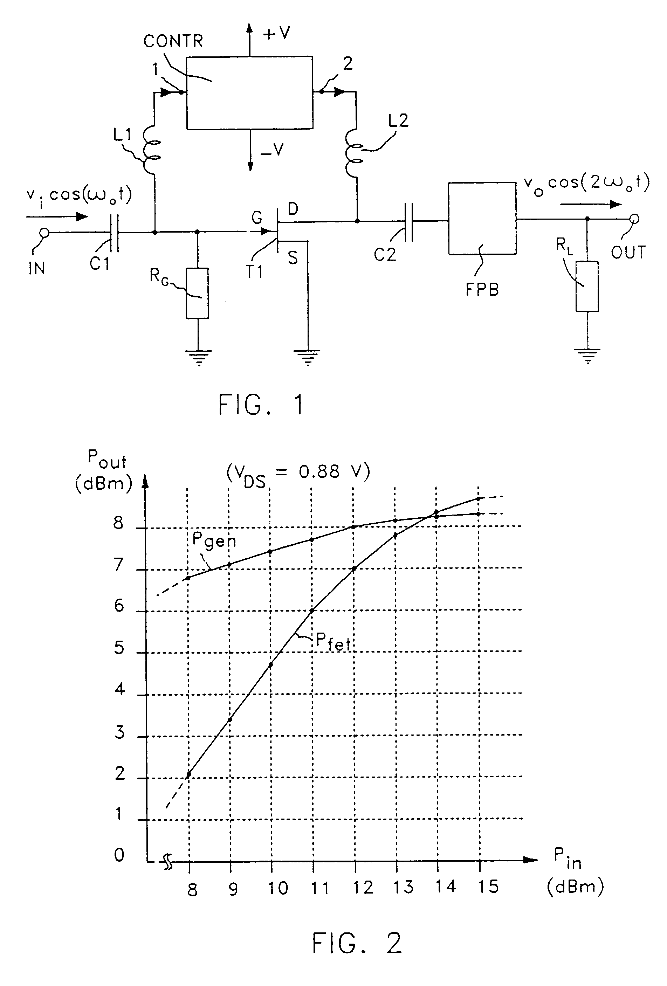

With reference to FIG. 1, T1 indicates a MESFET field effect transistor whose gate terminal $\underline{G}$ is connected to one end of a capacitor C1, of a resistor $R_G$ and of an inductor L1 respectively. The second ends C1, RG and L1 are respectively connected to an input gate IN, to ground and to the input terminal $\underline{1}$ of a block CONTR, whose output terminal $\underline{2}$ is connected to one end of an inductor L2. The other end of L2 is connected to the drain terminal $\underline{D}$ of T1 and to one end of a capacitor C2 whose other end is connected to the input of a bandpass filter FPB. The source terminal $\underline{S}$ of T1 is connected directly to ground. The output of the filter FPB is connected to an output gate OUT. A resistor $R_L$ is connected between the gate OUT and ground. The block CONTR is further connected to a source of direct current power which supplies the positive voltage +V and negative voltage -V.

In operation, the circuit of FIG. 1 relates to a radiofrequency frequency multiplier operating in the microwave range. More specifically, at the input gate IN arrives a signal $v_i cos(\omega_o t)$ coming from an oscillator not shown in the figure, whose oscillation frequency $f_o = \omega_o/2\pi$ is 12GHz. At the output gate OUT can be taken a signal $v_o cos(2\omega_o t)$ corresponding to the second harmonic component at a frequency of 24GHz.

The circuit is made by the thin film hybrid circuit technique. All the interconnections indicated are in microstrip. The inductor L1 is a high-impedance line for the oscillator signal at a frequency of 12GHz and a very low impedance line for the direct current (obtained by appropriate coupling of sections of line in $\lambda/4$ in a manner known to those skilled in the art). The inductor L2 is a very low impedance line for the direct current and a high impedance line for the 12GHz fundamental and for the 24GHz second harmonic at the output of T1. The capacitors C1 and C2 are made with coupled lines, the resistors $R_G$ and $R_L$ are microstrip line sections which constitute resistive terminations for the signal currents. The MESFET T1 used in the circuit is a NEC 673 well suited to the frequencies in question. The signal $v_i cos(\omega_o t)$ is coupled to the terminal of the source $\underline{G}$ of T1 by means of the capacitor C1 and the termination $R_G$.

The block CONTR, whose detailed operation is illustrated below, is a control circuit which polarizes in a variable manner the channel of the MESFET T1. The above control circuit consists predominantly of operational amplifiers and functions in a quasi-direct current condition. The polarization currents pass unaltered through L1 and L2 which behave like short circuits therefor; whereas otherwise the transit of the oscillator signals and the fundamental, with all the harmonics at the output of T1 toward the input and output respectively of the control circuit CONTR, is prevented because L1 and L2 behave like open circuits for signals with frequencies $\geq f_o$. Dually, the capacitance values of C1 and C2 are such that they behave like open circuits for the polarization currents and like short circuits for signals with frequencies $\geq f_o$.

In the absence of the signal $v_i cos(\omega_o t)$ at the gate IN, the block CONTR generates a weakly positive direct voltage $V_{GS}$. In this case the drain polarization current $I_D$ would tend to take on a value slightly higher than that of saturation $I_{DSS}$. Said value is not however reached because the block CONTR introduces an appropriate limitation in the value of the current $I_D$. Said block, in the absence of the signal $v_i cos(\omega_o t)$, generates at the terminal $\underline{2}$ an output voltage whose value is slightly less than that of supply +V. Since there are no resistors in series with L2, the output voltage of the block CONTR coincides with the polarization voltage $V_{DS}$ of the MESFET T1.

In the presence of the signal $v_i cos(\omega_o t)$ at the gate IN, the gate-source junction of T1 half-wave rectifies said signal. More specifically the positive half-waves make that a current circulates in the gate-source junction of T1, and in this case there is a small positive voltage across the junction and the drain current is the current $I_D$. The negative half-waves inversely polarize the gate-source junction of T1, causing drain current pulses $i_D(t)$. The capacitor C1 and the resistor $R_G$ form a highpass filtering section which filters the signal rectified by the gate-source junction of T1. In operation, there forms at the ends of C1 a direct voltage $V_{GS}$ of negative value corresponding to the direct component of the rectified signal $v_i \cos(\omega_o t)$. Said voltage $V_{GS}$ contributes to polarization of the gate-source junction of T1 and, through the inductor L1, is applied to the input terminal 1 of the block CONTR to control its operation.

The pulses of drain current $i_D$, as is known from Fourier's series development of the mathematical function $i_D(t)$, contain a sinusoidal component at the fundamental frequency $f_o$ plus the higher order harmonics.

The current $i_D$ passes through the capacitor C2 and reaches the band-pass filter FPB which lets pass unchanged toward the output gate OUT only the second harmonic component at the frequency of 24GHz. Said filter is provided in accordance with known design techniques of microwave filters. Its input section comprises a microstrip adaptation network which reflects the fundamental output again back toward the drain terminal of T1. The distance between FPB and T1 is such that the wave reflected is added in phase with the fundamental included in the current $i_D$, allowing transfer of a greater power to the second harmonic. The relative band width around the frequency $2f_o$ is approximately 10%, which is equivalent to 2.4GHz, and allows wide variations in the oscillator frequency.

The block CONTR controls the power $P_{out}$ acting as a feedforward controller. For this purpose it receives at the input the information on the power level of the signal $v_i \cos(\omega_o t)$, to which the voltage VGS is directly correlated, and outputs an appropriate voltage for polarization of the MESFET T1.

Stabilization of the power level by the block CONTR may be immediately appraised by an examination of FIG. 2, which shows a diagram having on the abscissa the power Pin of the oscillator signal $v_i \cos(\omega_o t)$ and on the ordinate the power $P_{out}$ of the output signal $v_i \cos(2\omega_o t)$. The diagram includes two curves indicated by $P_{fet}$ and $P_{gen}$. The curve $P_{fet}$ refers to a measurement performed only on the transistor T1 without the action of the block CONTR, while the curve $P_{gen}$ relates to the complete circuit of FIG. 1. In both cases the curves were obtained for a constant value of 0.88V of the polarization voltage $V_{DS}$. As may be seen, the stabilization effect is considerable.

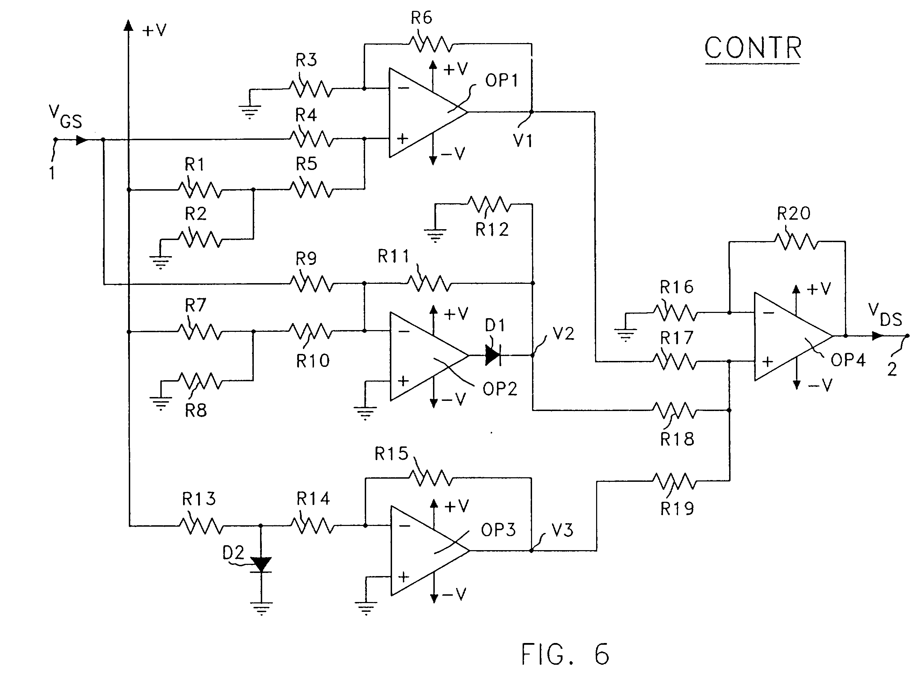

As may be seen in FIG. 1, and as better seen from an examination of the circuit of FIG. 6, the control circuit CONTR supplies directly the transistor T1 with a supply voltage which varies depending on the power of the input signal. The control action consists of the fact that varying the supply voltage of T1 varies in the same measure the polarization voltage $V_{DS}$, and consequently the maximum swing of voltage $V_{DS}$ on the load $R_L$, related to the output signal power by the relation $P_{out} = v_{DS}^2/2R_L$.

In all the examples of known signal generators including transistors used as amplifiers/distorters, there does not appear to be a control circuit regulating the power of the output signal by automatically varying the device supply voltage. On the contrary, in normal circuit applications of transistors, there are generally used appropriate precautions to stabilize the operating point against variations in the transistor supply voltage.

The feasibility of the block CONTR depends on whether there is a regulating function $V_{DS}(V_{GS})$ which holds constant the power $P_{out}$ with the variation of $P_{in}$. Once existence is ascertained, the input/output transfer characteristic of the block CONTR must approximate the curve $V_{DS}(V_{GS})$ for the MESFET T1 with a $P_{out}$ of approximately 8dBm. The existence of such a regulating function can be demonstrated theoretically. Its determinacion in relation to the frequency multiplier which is the object of the present invention is made directly experimentally as is shown below.

Demonstration of the existence of a regulation function $V_{DS}(V_{GS})$ consists of obtaining mathematically said function starting from the expression of the output power $P_{out}$. As is known, $P_{out} = (I_n^2 R_L)/2$, where $I_n$ is the current associated with the order $\underline{n}$ harmonic of the Fourier series development of the mathematical function representing the total drain current $i_D(t)$.

A method which makes it possible to find the function $i_D(t)$ and calculate the coefficients of the associated Fourier development series is illustrated in the appendix to chapter four (pages 144-148) of the volume entitled "Communication Circuits: Analysis and Design" by Kenneth K. Clarke and Donald T. Hess published by Addison-Wesley Publishing Company, 1971.

The method described assumes knowledge of the transfer characteristic $i_D(VGS)$ of the MESFET T1. Expression of the above characteristic, shown on pages 134 and 135 of said volume, in a first approximation is $i_D = I_{DSS}(1 - v_{GS}/V_p)^2$, where the term $I_{DSS}$ is the drain saturation current (drain current of the MESFET for $V_{GS} = 0$, with any $v_{DS}$ value in the saturation zone) and the term $V_p$ is the pinch-off voltage (value of $V_{GS}$ for $i_D = 0$).

In said volume it is also shown a chart of the current $i_D(t)$ obtained by points in a subsequent step of the method projecting the points of a function $v_{GS}(t) = v_i \cos(\omega_o t)$ on the transfer function $i_D(v_{GS})$ of the MESFET. The chart shows a succession of current pulses $i_D(t)$ in the correspondence with the positive half-periods of $v_i \cos(\omega_o t)$. The width of each pulse corresponds to the half-wave fraction of $v_i$ in which circulates drain current in the MESFET, as happens for an amplifier operating in class C. Calculation of the Fourier coefficients is then completed with the help of a parameter $\phi$ called 'circulation angle' and introduced to limit the field of integration to the actual width of the current pulse $i_D$.

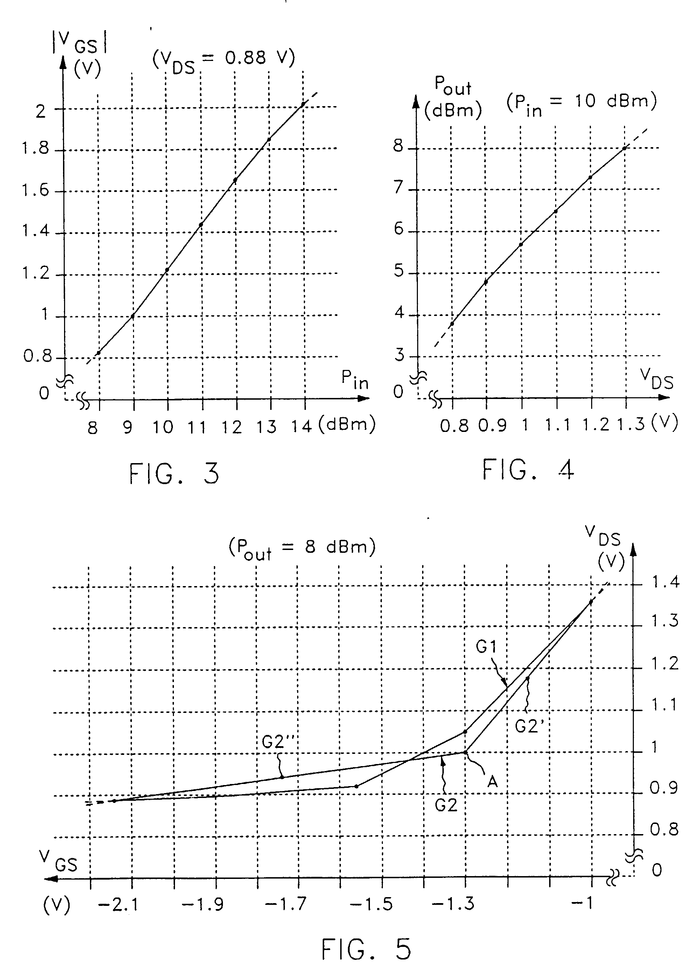

In the examples shown in FIG. 4.A-2 on page 147 of the above mentioned volume, it is $\phi = \arccos(V_p/v_i)$, where $v_i$ is the maximum amplitude of the signal $v_i \cos(\omega_o t)$ and $V_p$ is the pinch-off voltage of the MESFET. In the majority of practical applications, as for example in the case for T1, the circulation angle $\phi$ is also a function of the polarization values $V_{GS}$ and $V_{DS}$.

In the final phase of the method there is found the mathematical expression of the generic coefficient In.

The latter is a rather complex function of the angle $\phi$ and of the peak value $I_p$ of the current pulse $i_D$. The peak $I_p$ depends in turn on $I_{DSS}$ and on the square of $v_i$.

The above mentioned calculation method is applicable also in the case of MESFET T1, because in this case also the current $i_D(t)$ consists of a succession of pulses similar to those of the above chart. The principal differences between the operation of T1 and that of the FET of the mentioned method is that in T1 the pulses $i_D$(t) circulate in the correspondence with the negative half-waves of $v_i \cos(\omega_o t)$ and T1 is piloted in the linear zone starting from saturation rather than from interdiction. As may be seen, the size of the differences is not particularly great.

A normalized representation ($I_n/I_p$) of the trend of the first three coefficients as a function of the angle $\phi$ is shown in FIG. 4.4-4 on page 102 of the volume mentioned above.

The power $P_{out} = (I_n^2 R_L)/2$ of a generic harmonic selected at the output, as may be deduced from the whole set of the above theoretical considerations, is a function of the physical parameters ($I_{DSS}, V_p$) of T1 and of the amplitude $v_i$ of the oscillation signal $v_i \cos(\omega_o t)$; therefore $P_{out} = P_{out}(I_{DDS}, V_p, v_i)$. Recalling that $V_{GS}$ depended on the rectification of the signal $v_i \cos(\omega_o t)$ by T1, we have $P_{out} = P_{out}(I_{DSS}, V_p, V_{GS})$.

The above theoretical discussion does not at all show the dependency of $P_{out}$ on the polarization voltage $V_{DS}$, because the first approximation did not take into account the channel resistor $r_o$ of T1. It is possible to take into account said resistor in the method of calculating the coefficients $I_n$ of the Fourier development of the current $i_D(t)$ by substituting for the saturation current $I_{DSS}$ a saturation current

$$I'_{IDSS} = I_{DSS}[1 + (V_{DS} + V_p)/(r_o I_{DSS})]$$

which shows in the expression of $P_{out}$ its dependency on $V_{DS}$.

Summarizing, the expression of $P_{out}$ is:

$$P_{out} = P_{out}(I_{DSS}, V_p, V_{GS}, V_{DS}).$$

Since after selection of the particular type of MESFET to be used in the circuit, the parameters $I_{DSS}$, $V_p$ and $r_o$ are constant, the expression of $P_{out}$ can be simplified, obtaining definitively

$$P_{out} = P_{out}(V_{GS}, V_{DS}).$$

It is now possible to determine the regulating function $V_{DS}(V_{GS})$ in a purely analytical manner by selecting first the order of the harmonic selected at the output and then determining the function Pout for said harmonic. Then the value of $P_{out}$ which is intended to stabilize is selected, namely a value which is generally not far from the maximum value which the FET is capable of transferring to the selected harmonic. Lastly, in the relation $P_{out}(V_{GS}, V_{DS}) = $ constant the variable $V_{DS}$ is made explicit, obtaining the desired regulating function $V_{DS}(V_{GS})$.

As can be seen, determination of the regulating function mathematically is difficult to achieve because too complicated. The sequence of steps of the calculation method is illustrated primarily to demonstrate the conceptual existence of such a function. In practice it is simpler to find the regulating function experimentally through a series of measurements made on the MESFET T1 as is shown in the discussion of FIGS. 3, 4 and 5 which relate to measurements made only on the MESFET T1, i.e. excluding the control circuit CONTR.

FIG. 3 shows a diagram having on the abscissa the logarithm of the power $P_{in}$ of the oscillator signal $v_i \cos(\omega_o t)$ and on the ordinate the polarization voltage module $V_{GS}$ of T1. The curve was plotted for a constant value of 0.88V of the polarization voltage $V_{DS}$. It can be seen that $V_{GS}$ increases linearly with the decimal logarithm of the power $P_{in}$, and it can therefore be deduced that the gate-source junction of T1 behaves like an oscillation signal power detector.

FIG. 4 shows a diagram having on the abscissa the polarization voltage $V_{DS}$ of T1 and on the ordinate the logarithm of the power $P_{out}$ of the second harmonic component $v_o \cos(2\omega_o t)$ measured on the load RL. The curve was plotted by taking to the input of T1 an oscillator signal having a constant power of 10dBm. It can be noted that the logarithm of $P_{out}$ depends almost linearly on VDS, which demonstrates the feasibility of a circuit regulating the $P_{out}$ by acting on the $V_{DS}$.

FIG. 5 shows a diagram having on the abscissa the voltage $V_{GS}$ and on the ordinate the polarization voltage $V_{DS}$ of T1. The chart includes two curves of which the first, indicated by G1, represents the regulating function $V_{DS}(V_{GS})$ obtained experimentally. The second, indicated by G2, represents the transfer function of the block CONTR. The curve G2 approximates the curve G1 by means of two segments of a straight line with different slopes G2' and G2", contiguous in a point A.

The curve G1 is obtained by points, causing the $P_{in}$ to vary and measuring the corresponding voltage $V_{GS}$. For each value of $V_{GS}$ the voltage $V_{DS}$ was varied until the power $P_{out}$ of the signal $v_o \cos(2\omega_o t)$ measured on the load $R_L$ had a constant value of 8dBm. On the ordinate are shown the corresponding values of $V_{DS}$. As may be seen the curve G1 has a decreasing exponential trend. The significant variation of the function $V_{DS}(V_{GS})$ occurs within approximately a third of the values shown on the abscissa axis $V_{GS}$. This characteristic lends itself well to the two-segment approximation of the curve G2. In fact, the segment G2' has a higher slope and approximates the first part of the function. The segment G2" has a lower slope and approximates the asymptotic part. The circuit of FIG. 6 synthesizes the curve G2 using operational amplifiers.

With reference to FIG. 6, OP1, OP2, OP3 and OP4 indicate four identical operational amplifiers supplied in common by the voltages +V and -V. The inverting input (-) of OP1 is connected to one end of two resistors R3 and R6 whose other ends are connected to ground and to the output of OP1 respectively. The noninverting terminal (+) of OP1 is connected to one end of two resistors R4 and R5, whose other ends are respectively connected to the input terminal 1 of the control circuit CONTR and to the middle point of the series of two resistors R1 and R2 which have their other ends connected to the source of the voltage +V and to ground.

The input (+) of OP2 is connected directly to ground. The input (-) of said operational amplifier is connected to one end of three resistors R9, R10 and R11, whose other ends are respectively connected to the input terminal 1 of CONTR, the middle point of the series of two resistors R7 and R8, and the cathode of a diode D1, whose anode is connected to the output of OP2. The other ends of R7 and R8 are respectively connected to the source of the voltage +V and ground. A resistor R12 is connected between the cathode of the diode D1 and ground.

The input (+) of OP3 is connected directly to ground. The input (-) of said operational is connected to one end of two resistors R14 and R15 whose other ends are respectively connected to the anode of a diode D2 and the output of OP3. A resistor R13 is connected between the source of the voltage +V and the anode of the diode D2 whose cathode is connected to ground.

The input (-) of OP4 is connected to one end of two resistors R16 and R20 whose other ends are respectively connected to ground and to the output of OP4, and the latter is connected to the terminal of output 2 of the circuit CONTR. The input (+) of OP4 is connected to one end of three resistors R17, R18 and R19 whose other ends are respectively connected to the output of OP1, the cathode of diode D1 and the output of OP3. The output voltages of OP1, OP2 and OP3 are indicated by V1, V2 and V3 respectively. The output voltage of OP4 is the polarization voltage VDS of the MESFET T1.

In operation, the operational amplifier OP1 is a noninverting voltage adder; its output voltage V1 is given by the expression $V1 = \mu_1 V_{GS} + K1$ , where $\mu_1$ is the closed-loop voltage gain of the adder OP1, and K1 is the voltage V1 for $V_{GS} = 0$. The term $\mu_1 > 0$ is determined by the choice of appropriate values of the resistors R1, R2, R3, R4, R5 and R6. The term K1 > 0 is determined by the product of the voltage +V multiplied by an appropriate relationship among said resistors. In the plane $(V_{DS}, V_{GS})$ of FIG. 5 the voltage V1 corresponds to a straight line with positive slope (not shown in the figure) parallel to the segment G2'.

The operational amplifier OP2 is an inverting voltage adder with a diode at the output which introduces a threshold value for the voltage VGS before which the output signal V2 is null. The voltage V2 is given by the following expression:

$$V2 = (-\mu_2 V_{GS} - K2) \times F_{scal}(V_{GS} - V_{SL})$$

where $-\mu_2$ is the closed loop voltage gain of the adder OP2 which is determined by appropriate values of the resistor s R7, R8, R9, R10, R11 and R12. -K2 is a term which depends on the product of the voltage +V multiplied by an appropriate relationship among the above resistors. $F_{scal}$ is the step function which is 0 for $|V_{GS}| \leq V_{SL}$ and is 1 for $|V_{GS}| > V_{SL}$, where $V_{SL}$ is an appropriately preset threshold value. In conclusion we have $V_2 = 0$ for $|V_{GS}| \leq V_{SL}$ and $V2 = -\mu_2 V_{GS} - K2$ for $|V_{GS}| > V_{SL}$; assuming $V_{SL} = -1,3$ V the above relations define a semi-straight line (not shown in FIG. 5) with negative slope and beginning at A.

The operational amplifier OP3 is an inverting amplifier whose output voltage V3 is given by the expression $V3 = -\mu_3 V_{K3}$, where $-\mu_3$ is the closed loop voltage gain of the amplifier OP3 determined by appropriate values of the resistors R13, R14 and R15, and $V_{K3}$ is a voltage which depends on the same resistors and on the voltage VD2 existing between the anode and the cathode of the diode D2 in conduction. As may be seen, V3 does not depend on $V_{GS}$ and accordingly in the plane $(V_{DS}, V_{GS})$ of FIG. 5, V3 corresponds to a straight line (not shown in the figures) parallel to the axis $V_{GS}$ and distant $-V_{K3}$ therefrom. The voltage V3 compensates the current variations $i_D(t)$ caused by thermal variations of the gate-source junction of the MESFET T1.

The operational amplifier OP4 is a noninverting voltage adder whose output voltage VDS is given by the expression $V_{DS} = \mu_4(V1 + V2 + V3)$, where $\mu_4$ is the closed loop voltage gain of the amplifier OP4 determined by appropriated values of the resistors R16, R20.

Assuming $\mu_4 = 1$, the voltage $V_{DS} = V1 + V2 + V3$ is represented by the curve G2 of FIG. 5, which can be obtained by selecting first the point A (1,-1.3) and then assigning the values of $\mu_1$, $\mu_2$ e $\mu_3$, with the condition $\mu_1 \geq \mu_2$.

The circuit shown in FIG. 1 lends itself to broad generalizations about the range of operating frequencies, both for the value of the power to be stabilized and the type of transistor used.

For example, it is possible to choose at the output a high order harmonic in the microwave range starting from an oscillator signal with very much lower frequency. In this case the input circuitry of T1 is made using discrete components while the output part is of microstrip. In general, depending on the oscillator signal frequency, it is necessary to correctly dimension the values of C1, L1, L2 and choose the most cost-effective transistor on the basis of the harmonic order preselected, the value of C2 and the centre-band frequency of the filter FPB. It may prove advantageous, if the case allows, to adopt a tunable band-pass filter FPB, i.e. whose pass-band can be tuned at will around any one of the harmonics included in the output signal of T1.

The curves G1 and G2 of FIG. 5 relate to the case of a second harmonic with power to be stabilized of 8dBm which, as shown by the curves $P_{fet}$ and $P_{gen}$ of FIG. 2, is a value near the maximum possible for T1. Lower powers to stabilize give rise for a given harmonic to a family of curves $V_{DS}(V_{GS})$ similar to those of FIG. 5 all mutually parallel. The form of the regulating curve $V_{DS}(V_{GS})$ with the variation of the harmonic order selected at the output does not depart significantly from the exponential one shown by the curve G1 (FIG. 5). However, the decay constant can vary but this does not affect the possibility of using the control circuit CONTR on condition of selecting an appropriate point A in the approximation to two segments of the curve G2 (FIG. 5).

It is also possible to synthesize the generic regulation function $V_{DS}(V_{GS})$ by approximating it with a broken line with more than two segments; in this case the circuit CONTR of FIG. 6 must include N-1 inverting adders like OP2, N being the number of segments of the broken line. The only precaution is to vary the gain of the amplifiers and the diode intervention thresholds.

As concerns T1, if the frequencies involved allow, it is possible to use a bipolar transistor (BJT). Indeed, both the FET and the BJT are active devices with three terminals and can be considered, as concerns the controlled signal, as current generators, voltage-controlled for FET or current-controlled for BJT. As is known, the above devices, to operate, must be polarized by means of appropriate resistive networks connected to the battery. The input signal level and the polarization voltages and currents determine the manner of operation of the transistor.

In the case of BJT, the control circuit CONTR varies the polarization voltage $V_{CE}$ between the collector and emitter terminals in accordance with a regulating function $V_{CE}(I_B)$ which has a trend similar to that of the function $V_{DS}(V_{GS})$ determined for the FET. The basic polarization current IB is supplied primarily by the oscillator signal $v_i\cos(\omega_o t)$ rectified by the above mentioned junction.

Lastly, it is possible to introduce a minimal variation in the circuit of FIG. 1 by putting in series with L2 a resistor having a value approximately equal to the channel resistance $r_o$ to sensitize the action of the control circuit CONTR. In the case of BJT it is cost-effective to introduce said added resistor in series with the emitter. In both cases the control circuit CONTR must supply a regulation voltage equal to the previous one plus a constant value to allow for circulation of the direct component $I_D$ of the current $i_D(t)$ on the added resistor. The overall regulation voltage can be obtained by adding an appropriate voltage divider at the noninverting input of OP4 (FIG. 6).

**Claims**

1. Radiofrequency frequency multiplier comprising a transistor (T1) which amplifies and distorts an input oscillator signal, a band-pass filter (FPB) which selects a preestablished N-order harmonic included in the transistor output current, and an automatic level control circuit (CONTR) placed between the input terminals (G-S) and the output terminals (D-S) of said transistor (T1) which holds constant the power ($P_{out}$) of said N-order harmonic present at the output of the band-pass filter (FPB), **characterized in that** said frequency multiplier includes means (T1, $R_G$, C1, L1) for generating a control voltage ($V_{GS}$) directly correlated with the power level ($P_{in}$) of the input oscillator signal ($v_i\cos(\omega_o t)$), **and in that** said control circuit (CONTR) comprises voltage and current generator means (OP1, OP2, OP3, OP4, D1, D2) for polarization of said transistor (T1), said means being controlled by said control voltage ($V_{GS}$) in order to generate a variable polarization voltage ($V_{DS}$) between said output terminals (D-S) of the transistor (T1) in a preset manner inversely correlated with the level variation of the control voltage ($V_{GS}$).

2. Radiofrequency frequency multiplier in accordance with claim 1, characterized in that said oscillator signal reaches the input terminals (G-S) of the transistor (T1) through a high-pass filter (C1,$R_G$); and in that the transistor (T1) half-wave rectifies the oscillator signal, generating at the output of said high-pass filter (C1,$R_G$) a direct component which coincides with said control voltage ($V_{GS}$).

3. Radiofrequency frequency multiplier in accordance with claim 1, characterized in that said automatic level control circuit (CONTR) is connected to said transistor (T1) by means of suitable connection means comprising:

   - a first inductor (L1) which connects the output of said high-pass filter (C1,$R_G$) with the input (1) of said control circuit (CONTR), allowing said control voltage ($V_{GS}$) to pass and blocking said oscillator signal, and
   - a second inductor (L2) placed in series with the output (2) of said control circuit (CONTR) which lets pass only the direct component of the output current of said transistor (T1).

4. Radiofrequency frequency multiplier in accordance with claim 1, characterized in that said means belonging to said control circuit (CONTR) comprise:

   - a first device (OP1) which generates a first voltage (V1) subtracting, from an initially preestablished voltage, a voltage obtained by multiplying by a first multiplicative constant the absolute value of said control voltage (VGS),

- second devices (OP2,D1) which generate second voltages (V2) by multiplying, by respective second constants the absolute value of said control voltage ($V_{GS}$) and generate null voltages until said absolute control voltage value is less than a threshold value assigned to each second device,
- a third device (OP3,D2) which generates a voltage varying as a function of the temperature and compensating the thermal gain variation of the transistor (T1), and
- a fourth device (OP4) which generates said variable polarization voltage ($V_{DS}$) of the transistor (T1) by adding the voltages generated by said first, second and third devices.

5. Radiofrequency frequency multiplier in accordance with claim 4, characterized in that said threshold values are mutually different, said first multiplicative constant is greater than or equal to the larger of said second multiplicative constants and said second multiplicative constants are inversely correlated with the threshold values of the respective second devices.

6. Radiofrequency frequency multiplier in accordance with claim 4, characterized in that:

- said first device is a first operational amplifier (OP1) inverting voltage adder whose gain corresponds to said first multiplicative constant,
- said second devices are second operational amplifiers (OP2) noninverting voltage adders each having in series with the output a diode (D1) which conducts for absolute control voltage values ($V_{GS}$) greater than said respective threshold value and wherein the gain of said second operationals (OP2) corresponds to said second multiplicative constants,
- said third device is a third inverting operational amplifier (OP3) which amplifies the anode-cathode voltage of a diode (D2) in conduction, and
- said fourth device is a fourth operational amplifier (OP4) noninverting voltage adder.

7. Radiofrequency frequency multiplier in accordance with claim 6, characterized in that said fourth operational amplifier (OP4) limits the maximum current circulating in the transistor (T1).

8. Radiofrequency frequency multiplier in accordance with claim 4, characterized in that said initially preestablished voltage is approximately the supply voltage, the number of said second devices (OP2,D1) is one and said respective threshold value is approximately one third the maximum value of said control voltage ($V_{GS}$).

9. Radiofrequency frequency multiplier in accordance with claim 1, characterized in that said transistor is a MESFET, the oscillator signal frequency is in the microwave range and said band-pass filter (FPB) allows the second harmonic of the oscillator signal to pass.

10. Radiofrequency frequency multiplier in accordance with claim 1 or 3, characterized in that in series with said second inductor (L2) is connected a resistor having a value approximately equal to that of the resistor offered by said transistor (T1) between its output terminals (D-S).

**Patentansprüche**

1. Der Radiofrequenzvervielfacher, der bestückt ist mit einen Transistor (T1), über den ein eingehende Oszillationssignal verstärkt und verzerrt wird, sowie mit einem Bandpaßfilter (FPB), über den eine im Ausgangsstrom des Transistors enthaltene Oberwelle einer vorher definierten Größenordnung N selektioniert werden kann, sowie weiterhin bestückt mit einem Regelkreis zur automatischen pegelregelung (CONTR), welcher zwischen den Eingangsklemmen (G-S) und den Ausgangsklemmen (D-S) des besagten Transistors (T1) installiert wird und welcher die Leistung ($P_{out}$) der besagten, im Ausgang des Bandpaßfilters (FPB) präsenten Oberwellen einer vorher definierten Größenordnung N konstant hält; ist dadurch gekennzeichnet, daß im besagten Radiofrequenzvervielfacher Mittel installiert sind (T1, $R_G$, C1, L1), die eine Steuerspannung ($V_{GS}$) erzeugen, welche in direktem Bezug steht zum Leistungspegel ($P_{in}$) des eingehenden Oszillationssignals ($v_i cos(\omega_o t)$), und daß zum besagten Regelkreis zur automatischen Pegelregelung (CONTR) Mittel zur Voltspannungs- und Stromerzeugung (OP1, OP2, OP3, OP4, D1, D2) gehören, die zur Polarisation des besagten Transistors (T1) dienen; diese Mittel werden durch die besagte Steuerspannung ($V_{GS}$) geregelt, so daß eine veränderbarer Polarisationsspannung ($V_{DS}$) erzeugt wird, welche zwischen den besagten Ausgangsklemmen (D-S) des besagten Transistors (T1) präsent ist und eingestellt ist auf eine umgekehrte Art zur Veränderung des Pegels der Steuerspannung ($V_{GS}$).

2. Radiofrequenzvervielfacher entsprechend dem unter Punkt 1) der Inanspruchnahme beschriebenen Gerät, dadurch gekennzeichnet, daß besagtes Oszillationssignal durch einen Hochbandpaßfilter (C1, $R_G$) zum Transistor (T1) geleitet wird, und dadurch gekennzeichnet, daß der Transistor (T1) das Oszillationssignal halbwellengleichrichtet, indem am Ausgang des besagten Hochbandpaßfilters (C1, $R_G$) eine Gleichstromkomponente erzeugt wird, welche mit der besagten Steuerspannung ($V_{GS}$) übereinstimmt.

3. Radiofrequenzvervielfacher entsprechend dem unter Punkt 1) der Inanspruchnahme beschriebenen Gerät, dadurch gekennzeichnet, daß der besagte Regelkreis zur automatischen Pegelregelung (CONTR) über entsprechende Verbindungen an besagten Transistor (T1) angeschlossen ist; zu diesen Verbindungen gehören:

- ein erster Induktor (L1) zur Verbindung des Ausgangs des besagten Hochbandpaßfilters (C1, $R_G$) mit den Eingang (1) des besagten Regelkreises (CONTR), so daß die besagte Steuerspannung ($V_{GS}$) den Durchlaß und die Sperrung des besagten Oszillationssignal ermöglicht;
- ein zweiter Induktor (L2), der mit dem Ausgang (2) des besagten Regelkreises (CONTR) in Reihe geschaltet ist und lediglich den Gleichstromanteil des Ausgangsstroms des besagten Transistors (T1) durchläßt.

4. Radiofrequenzvervielfacher entsprechend dem unter Punkt 1) der Inanspruchnahme beschriebenen Gerät, dadurch gekennzeichnet, daß zu den besagten, zum besagten Regelkreis (CONTR) gehörenden Mitteln folgende Geräte gehören:

- ein erstes Gerät (OP1), welches eine erste Voltspannung (V1) erzeugt, indem von einer anfänglich voreingestellten Voltspannung eine Voltspannung abgezogen wird, welche über Vervielfältigung des absoluten Wertes der besagten Steuerspannung ($V_{GS}$) mittels einer ersten Vervielfältigungskonstante erzielt wird;
- zweite Geräte (OP2, D1), welche zweite Voltspannungen (V2) erzeugen, indem der absolute Wert der besagten Steuerspannung ($V_{GS}$) mittels entsprechender zweiter Vervielfältigungskonstanten vervielfältigt wird und welche eine Null-Voltspannung erzeugen, bis daß der Wert der besagten Steuerspannung unter dem jedem zweiten Gerät zugeordneten Schwellenwert liegt;
- ein drittes Gerät (OP3, D2), welches eine Voltspannung erzeugt, die in Funktion zur Temperatur variiert, so daß die Veränderung der thermischen Leistung des Transistors (T1) ausgeglichen werden,
- ein viertes Gerät (OP4), welches die besagte Polarisationsspannung ($V_{DS}$) des Transistors (T1) erzeugt, in die vom ersten, zweiten und dritten Gerät erzeugten Spannungen summiert werden.

5. Radiofrequenzvervielfacher entsprechend dem unter Punkt 4) der Inanspruchnahme beschriebenen Gerät, dadurch gekennzeichnet, daß die besagten Schwellenwerte gegenseitig unterschiedlich sind, daß die besagte Vervielfältigungskonstante größer oder gleich ist als bzw. wie die breitere der besagten zweiten Vervielfältigungskonstanten sowie dadurch gekennzeichnet, daß die besagten zweiten Vervielfältigungskonstanten in umgekehrten Bezug zu den Schwellenwerten der entsprechenden zweiten Geräte sind.

6. Radiofrequenzvervielfacher entsprechend dem unter Punkt 4) der Inanspruchnahme beschriebenen Gerät, dadurch gekennzeichnet, daß:

- es sich bei besagtem ersten Gerät um einen ersten Operationsverstärker (OP1) und umkehrenden Spannungssummierer handelt, dessen Leistung der besagten ersten Vervielfältigungskonstante entspricht;
- es sich bei den besagtem zweiten Geräten um zweite Operationsverstärker (OP2) und nicht umkehrende Spannungssummierer handelt, die zum Ausgang jeweils in Reihe geschaltet sind mit einer Diode (D1), welche zur absoluten Regelung von Spannungswerte ($V_{GS}$) dient, welche größer sind als besagter Schwellenwert und innerhalb deren die Leistung der besagten zweiten Operationsverstärker (OP2) den besagten zweiten Vervielfältigungskonstanten entsprechen;
- es sich beim besagtem dritten Gerät um einen dritten Operationsverstärker (OP3) und umkehrenden Spannungssummierer handelt, über den die Anoden-/Kathodenspannung einer im Leitung befindlichen Diode (D2) verstärkt wird;
- es sich beim besagtem vierten Gerät um einen vierten Operationsverstärker (OP4) und nicht umkehrenden Spannungssummierer handelt.

7. Radiofrequenzvervielfacher entsprechend dem unter Punkt 6) der Inanspruchnahme beschriebenen Gerät, dadurch gekennzeichnet, daß der besagte vierte Operationsverstärker (OP4) den im Transistor (T1) zirkulierenden Maximalstrom begrenzt.

8. Radiofrequenzvervielfacher entsprechend dem unter Punkt 4) der Inanspruchnahme beschriebenen Gerät, dadurch gekennzeichnet, daß besagte voreingestellte Voltspannung der Speisespannung angenähert wird und daß die Anzahl der besagten zweiten Geräte (OP2, D1) gleich eins ist und daß der entsprechende besagte Schwellenwert etwa ein Drittel des Höchstwertes der besagten Steuerspannung ($V_{GS}$) entspricht.

**9.** Radiofrequenzvervielfacher entsprechend dem unter Punkt 1) der Inanspruchnahme beschriebenen Gerät, dadurch gekennzeichnet, daß es sich bei besagtem Transistor um einen MESFET Feldtransistor handelt, daß die Frequenz des Oszillationssignals im Mikrowellenbereich liegt und dadurch gekennzeichnet, daß der besagte Bandpaßfilter (FPB) den Durchgang der zweiten Oberwelle des Oszillationssignals ermöglicht.

**10.** Radiofrequenzvervielfacher entsprechend dem unter Punkt 1) oder 3) der Inanspruchnahme beschriebenen Gerät, dadurch gekennzeichnet, daß in Reihe geschaltet mit dem besagten zweiten Induktor (L2) ein Widerstand angeschlossen ist, dessen Wert annähernd gleich dem des Widerstandes zwischen den Ausgangsklemmen (D-S) des besagten Transistors (T1) ist.

**Revendications**

**1.** Multiplicateur de fréquence à fréquence radio comportant un transistor (T1) qui amplifie et distorsionne un signal d'oscillateur, un filtre passe-bande (FPB) qui sélectionne une harmonique préétablie d'ordre N comprise dans le courant de sortie du transistor, et un circuit de contrôle automatique de niveau (CONTR) situé entre les bornes d'entrée (G-S) et de sortie (D-S) dudit transistor (T1) qui maintient constante la puissance ($P_{out}$) de ladite harmonique d'ordre N à la sortie du filtre passe-bande (FPB), caractérisé par le fait que ledit multiplicateur de fréquence comporte des moyens (T1, $R_G$, C1, L1) pour la génération d'une tension de contrôle ($V_{GS}$) en corrélation directe avec le niveau de puissance ($P_{in}$) du signal d'oscillateur ($v_i \cos(\omega_o t)$); que ce circuit de contrôle automatique de niveau (CONTR) comporte des moyens (OP1, OP2, OP3, OP4, D1, D2) générateurs de tension et de courant pour la polarisation du transistor (T1); que ces moyens sont contrôlés par ladite tension de contrôle ($V_{GS}$) pour la génération d'une tension de polarisation variable ($V_{DS}$) entre lesdites bornes d'entrée (G-S) et de sortie (D-S) dudit transistor (T1) avec une modalité préétablie en corrélation inverse avec la variation de niveau de la tension de contrôle ($V_{GS}$).

**2.** Multiplicateur de fréquence à fréquence radio selon la revendication 1, caractérisé par le fait que ce signal d'oscillateur parvient aux bornes d'entrée (G-S) du transistor T1 à travers un filtre passe-haut (C1, $R_G$); et que le transistor (T1) rectifie à chaque demi-onde le signal d'oscillateur en générant à la sortie dudit filtre passe-haut (C1, $R_G$) une composante continue qui coïncide avec ladite tension de contrôle ($V_{GS}$).

**3.** Multiplicateur de fréquence à fréquence radio selon la revendication 1, caractérisé par le fait que ledit circuit de contrôle automatique (CONTR) est connecté au transistor (T1) par des moyens de connexions opportuns qui comprennent:

     un premier inducteur (L1) qui relie la sortie dudit filtre passe-haut (C1, $R_G$) à l'entrée (1) dudit circuit de contrôle (CONTR) en laissant passer ladite tension de contrôle ($V_{GS}$) et en bloquant ledit signal d'oscillateur; et
     un deuxième inducteur (L2) placé en série à la sortie (2) dudit circuit de contrôle (CONTR) qui ne laisse passer que la composante continue du courant de sortie dudit transistor (T1).

**4.** Multiplicateur de fréquence à fréquence radio selon la revendication 1, caractérisé par le fait que ces moyens appartenant audit circuit de contrôle (CONTR) comprennent:

-    un premier dispositif (OP1) qui génère une première tension (V1) en soustrayant d'une valeur de tension préétablie une tension obtenue en multipliant par une première constante la valeur absolue de ladite tension de contrôle (VGS);
-    deux deuxièmes dispositifs (OP2, D1) qui génèrent de secondes tensions (V2) en multipliant par de respectives secondes constantes la valeur absolue de ladite tension de contrôle ($V_{GS}$) et génèrent des valeurs nulles de tension tant que ladite valeur absolue de la tension de contrôle est inférieure à une valeur de seuil attribuée à chacun desdits dispositifs;

     un troisième dispositif (OP3, D2) qui génère une tension variable en fonction de la température, en compensant la variation thermique de gain du transistor (TI); et
     un quatrième dispositif (OP4) qui génère ladite tension de polarisation variable ($V_{DS}$) du transistor (T1) en additionnant les tensions générées par le premier, les deuxièmes et le troisième dispositifs mentionnés plus haut.

**5.** Multiplicateur de fréquence à fréquence radio selon la revendication 4, caractérisé par le fait que lesdites valeurs de seuil sont différentes entre elles; que ladite première constante multiplicative est supérieure ou égale à la plus grande desdites secondes constantes multiplicatives; et que ces secondes constantes multiplicatives sont inversement en corrélation avec les valeurs de seuil des deuxièmes dispositifs respectifs.

**6.** Multiplicateur de fréquence à fréquence radio selon la revendication 4, caractérisé par le fait que:

- ledit premier dispositif est un premier amplificateur opérationnel (OP1) additionneur de tension de type inverseur dont le gain correspond à ladite première constante multiplicative;
- lesdits deuxièmes dispositifs sont des deuxièmes amplificateurs opérationnels (OP2) additionneurs de tension non-inverseurs, dont chacun a en série à la sortie une diode (D1) qui entre en conduction pour des valeurs absolues de la tension de contrôle ($V_{GS}$) supérieures à ladite valeur respective de seuil, où le gain desdits deuxièmes opérationnels (OP2) correspond auxdites deuxièmes constantes multiplicatives;
- ledit troisième dispositif est un troisième amplificateur opérationnel (OP3) de type inverseur qui amplifie la tension anode-cathode d'une diode (D2) en conduction; et
- ledit quatrième dispositif est un quatrième amplificateur opérationnel (OP4) additionneur de tension de type non-inverseur.

**7.** Multiplicateur de fréquence à fréquence radio selon la revendication 6, caractérisé par le fait que ce quatrième amplificateur opérationnel (OP4) limite la valeur maximum de courant (iD) qui circule dans le transistor (T1).

**8.** Multiplicateur de fréquence à fréquence radio selon la revendication 4, caractérisé par le fait que cette tension préétablie initialement est approximativement la tension d'alimentation; que le nombre de ces deuxièmes dispositifs (OP2, D1) est un; et que ladite valeur respective de seuil est d'environ un tiers de la valeur maximum de ladite tension de contrôle ($V_{GS}$).

**9.** Multiplicateur de fréquence à fréquence radio selon la revendication 1, caractérisé par le fait que ledit transistor est un MESFET; que la fréquence du signal d'oscillateur est comprise dans le champ des micro-ondes et que ledit filtre passe-bande (FPB) laisse passer la seconde harmonique du signal d'oscillateur.

**10.** Multiplicateur de fréquence à fréquence radio selon les revendications 1 à 3, caractérisé par le fait qu'en série audit second inducteur (L2) est connectée une résistance de valeur à peu près égale à celle de la résistance présentée par ledit transistor (T1) entre ses bornes de sortie (D-S).

FIG. 1

FIG. 2

FIG. 3

FIG. 4

FIG. 5

FIG. 6

EP 0 548 542 B1